(19) Europäisches Patentamt
European Patent Office
Office européen des brevets

(11) EP 2 784 521 B1

(12) EUROPEAN PATENT SPECIFICATION

(45) Date of publication and mention
of the grant of the patent:
**17.04.2019 Bulletin 2019/16**

(51) Int Cl.:
*G01R 17/16* (2006.01)    *G01R 27/14* (2006.01)
*G01D 5/16* (2006.01)    *G01L 1/22* (2006.01)
*G01D 3/036* (2006.01)

(21) Application number: **13161775.5**

(22) Date of filing: **28.03.2013**

(54) **Sensor apparatus and method**

Sensoranordnung und Verfahren

Procédé et dispositif à capteur

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**01.10.2014 Bulletin 2014/40**

(73) Proprietor: **Fraunhofer-Gesellschaft zur
Förderung der
angewandten Forschung e.V.
80686 München (DE)**

(72) Inventors:
• **Leman, Olivier
91056 Erlangen (DE)**
• **Nikas, Antonios
91054 Erlangen (DE)**
• **Hauer, Johann
91058 Erlangen (DE)**

(74) Representative: **Burger, Markus
Schoppe, Zimmermann, Stöckeler
Zinkler, Schenk & Partner mbB
Patentanwälte
Radlkoferstraße 2
81373 München (DE)**

(56) References cited:
**EP-A1- 1 790 988    WO-A2-2010/001077
US-A- 4 492 122**

• **MARK LEMKIN ET AL: "A Three-Axis
Micromachined Accelerometer with a CMOS
Position-Sense Interface and Digital Offset-Trim
Electronics", IEEE JOURNAL OF SOLID-STATE
CIRCUITS, IEEE SERVICE CENTER,
PISCATAWAY, NJ, USA, vol. 34, no. 4, April 1999
(1999-04), XP011060979, ISSN: 0018-9200**
• **LEMAN O ET AL: "An inertial smart-sensor based
on silicon nanowires for wireless sportive activity
monitoring", 2011 IEEE SENSORS
PROCEEDINGS : LIMERICK, IRELAND, 28 - 31
OCTOBER 2011, IEEE, PISCATAWAY, NJ, 28
October 2011 (2011-10-28), pages 1429-1432,
XP032093314, DOI:
10.1109/ICSENS.2011.6127112 ISBN:
978-1-4244-9290-9**

**Description**

The present invention relates to a sensor arrangement and to a method for operating the same. Some embodiments of the present invention relate to a system for resistive sensor bias and readout.

US 7,646,190 proposes a compensation of the positive temperature coefficient of a resistive sensor with the temperature characteristic of a diode placed in the bias path of the resistive sensor. The correct compensation thus relies on a favorable relation between the temperature characteristics of two devices built with two different processes and implementing different physical principles. This compensation scheme might hence need a trimming to reach a convenient temperature compensation, which increases the production costs of the complete sensor system. Besides this previous invention does not include amplification of the output signal.

US 3,665,756 and US 5,686,826 propose a Wheatstone bridge setup for resistive sensors with temperature compensation, however no amplification of the output voltage is proposed.

US 4,345,477 proposes a Wheatstone bridge setup for piezoresistive sensors coupled to an instrumentation amplifier for signal amplification. This previous system requires the bias of the Wheatstone bridge and three operational amplifiers, this solution is therefore not favorable to reductions in the power consumption. Besides, at least two amplifiers significantly contribute to the sensor noise.

US7,451,655 proposes an integrated circuit that implements an analog front-end for sensors with resistive Wheatstone bridge readout. The ASIC biases the bridge with a regulated voltage and amplifies its signal with an instrumentation amplifier. This solution requires a total of four operational amplifier plus a precision regulator for bridge bias, which is not favorable to both a reduced power consumption and a low-noise implementation.

A physical quantity detection device with temperature compensation is shown in the US 6,724,202 B2. Thereby, first and second resistors (sensing elements) are connected in series between first and second potentials. The junction point voltage between the first and second resistor is supplied to an inverting input of a first operational amplifier. The non-inverting input is supplied with a reference voltage generated by third and fourth resistors. A feedback resistor is connected between output and inverting input of the operational amplifier. The difference between temperature coefficient of resistor of the sensing elements and temperature coefficient of sensitivity is equalized to temperature coefficient of resistor of the feedback resistor. Further, the reference voltage is unchanged in accordance with the detected physical quantity or temperature variation. This system implements a compensation of both the temperature coefficient of resistance and the temperature coefficient of sensitivity of the sensor. However this comes at the cost of a complicated trimming, thus increasing the overall system cost.

Further, a circuit for amplifying a signal representing a variation in resistance of a variable resistance and corresponding sensor is disclosed in the US 2011/0248783 A1. The circuit comprises at least one first load linked to a drain terminal of a first transistor whose source terminal is associated with a variable resistance, in such a way that the voltage variations between the terminals of the variable resistance appear amplified at the terminals of the first load. This previous system achieves a maximal power efficiency since it reuses the same current for both the bias of the amplifier core and the bias of the variable resistance. However no solution for a linear continuous-time closed-loop operation is proposed, meaning that the system is intrinsically an open-loop structure.

Moreover, a voltage amplifier for constant voltage biasing and amplifying signals from a magnetic sensor is described in the US 4,786,993. Electrically, the resistance of the sensor is disposed between the inputs of a modified differential pair comprising a built-in offset obtained by source degeneration with a second resistance. The sensor bias voltage corresponds to the DC voltage drop across this same second resistance. Constant bias voltage for the sensor is provided independently of sensor resistance via a closed-loop control. DC (DC = direct current) feedback to the input stage balances current flow in both paths of the previous differential input stage to correct for DC offset arising from the matching errors between the devices, in particular between the degeneration resistance of the differential input stage and the sensor resistance. The amplified signal is related to an AC voltage across the magnetoresistive sensor. This system is suitable when the sensor signal bandwidth does not include DC, since the control loop sets the sensor bias point in the low-frequencies thus cancelling the effects of DC variations in the sensor resistance on the output differential mode voltage. In other words, this system behaves as a high-pass filter with respect to the sensor variations in resistance.

Furthermore, resistive sensor bias circuits and methods of operating the same are disclosed in the US 7,961,418 B2. Thereby, an example resistivity sense bias circuit for use with a magnetoresistive read head includes a current biasing portion configured to provide a bias current through the magnetoresistive read head thereby establishing a bias voltage across the magnetoresistive read head, a resistivity sensing portion coupled to the current biasing portion and configured to sense a change in the bias current based on a resistivity change of the magnetoresistive read head, and a voltage source to provide the bias voltage and to adjust the bias voltage in response to the resistivity change of the magnetoresistive read head. This other system is similar to US 4,786,993 excepted here the output differential mode voltage is sensitive to DC variations in the sensor resistance. The sensor DC bias-point is set via a digital control loop, so this digital control loop defines the low-frequency behavior of the system. However a common drawback of the systems featuring signal amplification disclosed in US 7,961,418 B2, US 4,786,993 and US 2011/0248783 A1 is that the system gain is defined by the properties of a transconductor and resistors, that's to say devices implemented with different technologies and appealing to different physical phenomena. This is not favorable to gain precision and gain stability with respect to temperature variations.

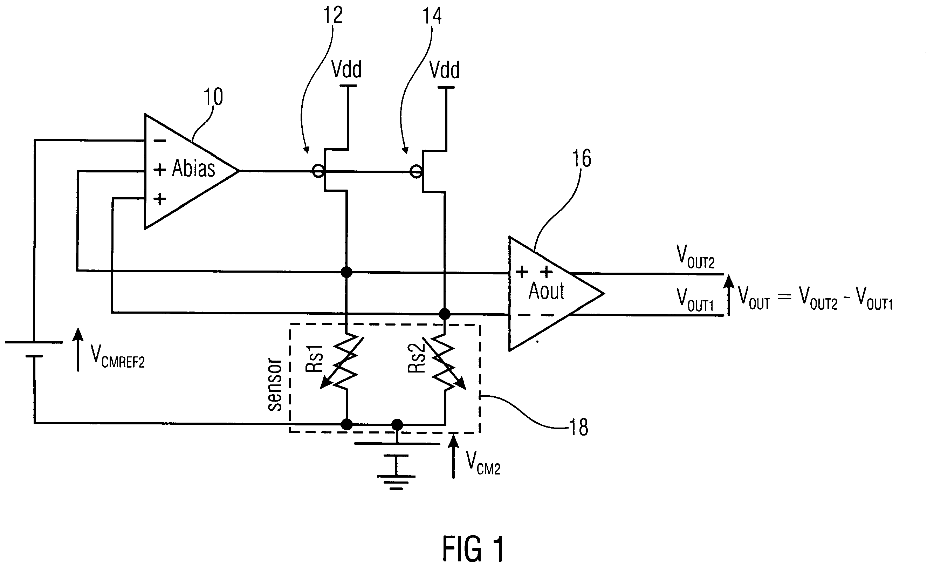

In the article (O. Leman, E. M. Boujamaa, W. Rahajandraibe, E. Kussener, S. Meillere, H. Barthelemy, G. Jourdan, P. Rey, "An inertial smart-sensor based on silicon nanowires for wireless sportive activity monitoring", 10th IEEE Conference on Sensors (SENSORS'11), Limerick, Ireland, 28-31 Oct. 2011) another solution is proposed. As shown in Fig. 1, it uses a specifically designed amplifier (Abias) 10 for sensor bias. This three-input amplifier (Abias) 10 controls two MOS (MOS = Metal Oxide Semiconductor) transistors 12 and 14 used as current sources, to set the common mode voltage of the sensor outputs, thus achieving sensor bias. An additional amplifier (Aout) 16 with high input impedance amplifies the differential mode of the sensor 18. The system, through the common mode feedback loop, provides a behavior similar to a full, 4-resistors Wheatstone bridge, with an interesting suppression of the nonlinear behavior associated with the non-push-pull implementation. However, supposing the voltage across the resistive detectors has to be as low as 100 mV, for example, to reduce the power dissipation of the detector, then a drawback of this solution is that the amplifier (Abias) 10 has to regulate a 100 mV common mode across the detectors ($V_{CMREF2}$).

The solutions for resistive sensor readout based on an instrumentation amplifier are not optimal for the noise and power-consumption criteria since they involve many operational amplifiers that need to be able to drive resistive feedback networks that are relatively low resistive loads, and in addition, at least two of these amplifiers need to feature a low-noise characteristic. Supposing the sensor is fragile and needs a small bias voltage (for example 100 mV or less) then additional precision electronic means are needed, thus driving the overall system more complicated and power-hungry. We propose a system that merges the resistive bridge with the amplifier. This system achieves an improved power-efficiency through the use of the same current to bias both the sensor and the output transconductor of the amplifier. This enables a precision, two-stage analog system that achieves a combination of a robust sensor bias and low-noise amplification of the sensor signal, with bandwidth including DC and a reduced power consumption. Solutions for untrimmed operation of the proposed invention featuring a compensation of the discrepancies between the sensor and the amplifier circuitry on the bias point are described in the following, thus helping to reduce the production costs.

US 4 492 122 A shows a circuit for linearization of a transducer. A circuit having a transducer which normally provides a non-linear output as a function of a stimulus to which the transducer is responsive. The circuit is provided with a feedback resistor from at least one of a pair of output terminals coupled to the transducer, and the feedback resistor is coupled to the power input of the transducer. Any change in the output voltage will cause a current change through the transducer, and this current change has a linearizing effect on the output voltage.

EP 1 790 988 A shows a detection circuit with a differential capacitive sensor and with an interface circuit having a first sense input and a second sense input, electrically connected to the differential capacitive sensor. Provided in the interface circuit are: a sense amplifier connected at input to the first sense input and to the second sense input and supplying an output signal related to a capacitive unbalancing of the differential capacitive sensor; and a common-mode control circuit, connected to the first sense input and to the second sense input and configured to control a common-mode electrical quantity present on the first sense input and on the second sense input.

In the article (Mark Lemkin, Bernhard E. Boser, "A Three-Axis Micromachined Accelerometer with a CMOS Position-Sense Interface and Digital Offset-Trim Electronics", IEEE JOURNAL OF SOLID-STATE CIRCUITS, VOL. 34, NO. 4, APRIL 1999) a three-axis micromachined accelerometer with a position-sense interface and digital offset-trim electronics is shown.

Therefore, it is the object of the present invention to provide a concept for providing a bias for a sensor that reduces or even avoids the above mentioned disadvantages.

This object is solved by a sensor arrangement according to claim 1 and a method, for operating such a sensor, according to claim 6. A sensor arrangement comprising a differential amplifier and a sensor is provided. Thereby, a terminal of the sensor is coupled to an input of the differential amplifier. An output of the differential amplifier is coupled to the terminal of the sensor for providing a bias for the sensor.

According to the concept of the present invention, a bias for a sensor connected to an input of a differential amplifier can be provided by a feedback path from an output of the differential amplifier to a terminal of the sensor.

Further, a sensor arrangement comprising a differential amplifier and a sensor is provided. The differential amplifier comprises a differential output and an output common mode control configured to control or regulate a common mode output voltage of the differential amplifier. The sensor is connected to a first input of the differential amplifier. Further, the sensor arrangement comprises a feedback path from the differential output of the differential amplifier to the first input of the differential amplifier, to provide a bias for the sensor.

Further, a method for operating a sensor arrangement comprising a differential amplifier and a sensor is provided. Thereby, a terminal of the sensor is coupled to an input of the differential amplifier. An output of the differential amplifier is coupled to the terminal of the sensor. The method comprises providing a bias for the sensor based on a voltage provided at the output of the differential amplifier.

Embodiments of the present invention are described herein making reference to the appended drawings.

Fig. 1    shows a schematic of a previous system for resistive sensor bias and readout, achieving a reduced sensor power dissipation and a reduced sensor bias voltage;

Fig. 2    shows a block diagram of a sensor arrangement according to an embodiment of the present invention;

Fig. 3    shows a block diagram of the differential amplifier of the sensor arrangement, according to an embodiment of the present invention;

Fig. 4    shows a schematic of a sensor arrangement according to a further embodiment of the present invention.

Fig. 5a    shows a schematic of the sensor arrangement exposed to a neutral stimulation, according to an embodiment of the present invention;

Fig. 5b    shows a schematic of the sensor arrangement exposed to a first stimulation, according to an embodiment of the present invention;

Fig. 5c    shows a schematic of the sensor arrangement exposed to a second stimulation, according to an embodiment of the present invention;

Fig. 6a    shows a schematic of a sensor comprising a reference sensor resistor, wherein the sensor is exposed to a first stimulation, according to an embodiment of the present invention;

Fig. 6b    shows a schematic of the sensor comprising the reference sensor resistor, wherein the sensor is exposed to a second stimulation, according to an embodiment of the present invention;

Fig. 7    shows a schematic of a common mode reference voltage provider, according to an embodiment of the present invention;

Fig. 8    shows a schematic of the differential amplifier according to an embodiment of the present invention;

Fig. 9    shows a schematic of the common mode control of the differential amplifier, according to an embodiment of the present invention;

Fig. 10    shows a schematic of the sensor arrangement, according to a further embodiment of the present invention; and

Fig. 11    shows a schematic of the sensor arrangement, according to a further embodiment of the present invention.

Elements with equal or equivalent functionality are denoted in the following description by equal or equivalent reference numerals.

In the following description, a plurality of details are set forth to provide a more thorough explanation of embodiments of the present invention. However, it will be apparent to those skilled in the art that embodiments of the present invention may be practiced without these specific details. In other instances, well-known structures and devices are shown in block diagram form rather than in detail in order to avoid obscuring embodiments of the present invention. In addition, features of the different embodiments described hereinafter may be combined with each other, unless specifically noted otherwise.

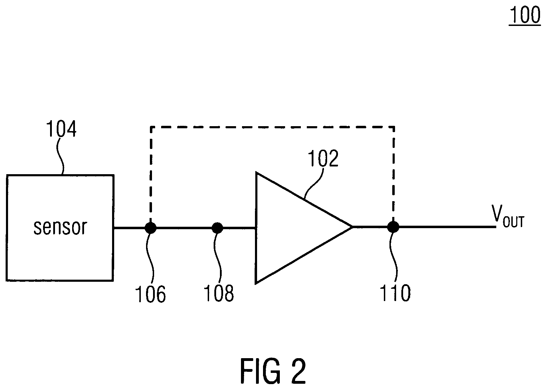

Fig. 2 shows a block diagram of a sensor arrangement 100 according to an embodiment of the present invention. The sensor arrangement 100 comprises a differential amplifier 102 and a sensor 104. A terminal 106 of the sensor 104 is coupled to an input 108 of the differential amplifier 102, wherein an output 110 of the differential amplifier 102 is coupled to the terminal 106 of the sensor 104 for providing a bias for the sensor 104.

In some embodiments, the output 110 of the differential amplifier 102 can be a differential output 110, wherein the input 108 of the differential amplifier 102 can be a differential input 108. The differential input 108 of the differential amplifier 102 can comprise a first input terminal and a second input terminal. The differential output 110 of the differential amplifier 102 can comprise a first output terminal and a second output terminal.

Further, the sensor arrangement 100 can comprise a differential feedback path 112 from the differential output 110 of the differential amplifier 102 to the differential input 108 of the differential amplifier 102, in order to provide the bias for the sensor 104.

The differential amplifier 102 can be configured to provide at its output 110 a differential mode output voltage $V_{OUT}$. The differential mode output voltage $V_{OUT}$ can be a difference between a second potential $V_{OUT2}$ present at the second output terminal of the differential output 110 and a first potential $V_{OUT1}$ present at the first output terminal of the differential output 110 ($V_{OUT} = V_{OUT2} - V_{OUT1}$).

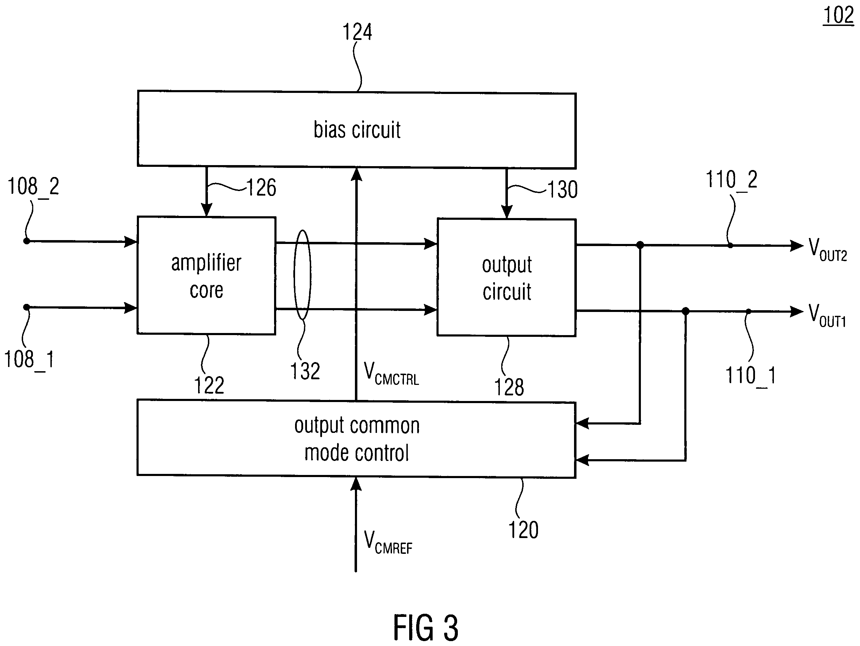

Fig. 3 shows a block diagram of the differential amplifier 102 according to an embodiment of the present invention. The differential amplifier 102 comprises a differential input 108 having a first input terminal 108_1 and a second input terminal 108_2, and a differential output 110 having a first output terminal 110_1 and a second output terminal 110_2.

As shown in Fig. 3, the differential amplifier 102 can comprise an output common mode control 120. The output common mode control 120 can be configured to control or regulate a common mode output voltage of the differential amplifier 102. Alternatively, the output common mode control 120 can be configured to control or regulate a gain of the differential amplifier 102. Naturally, the output common mode control 120 also can be configured to control or regulate, the common mode output voltage of the differential amplifier 102.

Further, the differential amplifier 102 can comprise a differential amplifier core 122 and a bias circuit 124. The differential amplifier core 122 can be connected to the differential input 108 of the differential amplifier 102, or in other words, to the first input terminal 108_1 and the second input terminal 108_2 of the differential input 108 of the differential amplifier 102.

The bias circuit 124 can be configured to provide a bias current 126 for the differential amplifier core 122. Thereby, the output common mode control 120 can be configured to control or regulate the bias current 126 provided by the bias circuit 124 for the differential amplifier core 122 based on a common mode reference voltage $V_{CMREF}$.

Further, the differential amplifier 102 can comprise a differential output circuit 128. The differential output circuit 128 can be connected to the differential amplifier core 122, wherein the bias circuit 124 can be configured to provide a bias current or bias currents 130 for the differential output circuit 128. The differential output circuit 128 can be configured to provide the differential mode output voltage $V_{OUT}$ based on the bias current(s) 130 provided by the bias circuit 124 and currents 132 provided by the differential amplifier core 122. Thereby, the output common mode control 120 can be configured to control or regulate the bias current(s) 130 provided by the bias circuit 124 for the output circuit 128 based on the common mode reference voltage $V_{CMREF}$.

Observe that the output common mode control 120 can also be configured to control or regulate both, the bias current 126 provided by the bias circuit 124 for the differential amplifier core 122 and the bias current(s) 130 provided by the bias circuit 124 for the differential output circuit 128, based (or in dependence) on the common mode reference voltage $V_{CMREF}$.

Moreover, the output common mode control 120 can be connected to the differential output 110 of the differential amplifier 102, or in other words, to the first output terminal 110_1 and the second output terminal 110_2 of the differential output 110 of the differential amplifier 102. In this case, the output common mode control 120 can be configured to control or regulate the bias current 126 or the bias current(s) 130 provided by the bias circuit 124 further based on the output voltages $V_{OUT2}$ and $V_{OUT1}$ provided at the differential output 110 of the differential amplifier 102.

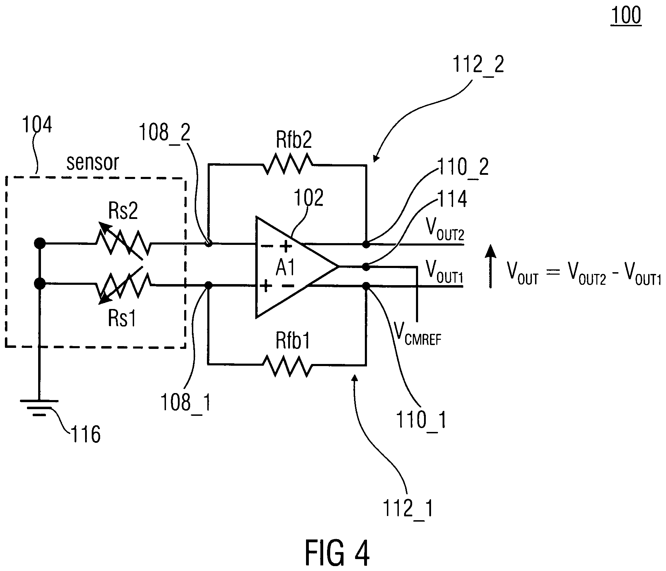

Fig. 4 shows a schematic of the sensor arrangement 100 according to a further embodiment of the present invention. The sensor arrangement 100 comprises the differential amplifier 102 and the sensor 104. The differential amplifier 102 comprises the differential output 110_1 and 110_2 and the output common mode control 120 (not shown) configured to control or regulate the common mode output voltage of the differential amplifier 102. The sensor 104 is connected to the differential input 108_1 and 108_2 of the differential amplifier 102. Further, the sensor arrangement 100 comprises a differential feedback path 112_1 and 112_2 from the differential output 110_1 and 110_2 to the differential input 108_1 and 108_2 of the differential amplifier 102, in order to provide a bias for the sensor 104.

As shown in Fig. 4, the differential feedback path 112_1 and 112_2 can comprise a first feedback path 112_1 from the first output terminal 110_1 of the differential output 110 to the first input terminal 108_1 of the differential input 108, and a second feedback path 112_2 from the second output 110_2 of the differential output 110 to the second input 108_2 of the differential input 108.

Thereby, the differential feedback path 112_1 and 112_2 can comprise two feedback resistors Rfb1 and Rfb2. Thereby, the first feedback resistor Rfb1 can be connected in series between the first input terminal 108_1 and the first output terminal 110_1 of the differential amplifier 102, in order to provide the first feedback path 112_1, wherein the second feedback resistor Rfb2 can be connected in series between the second input terminal 108_2 and the second output terminal 110_2 of the differential amplifier 102, in order to provide the second feedback path 112_2.

The sensor 104 can comprise two resistive sensor elements Rs1 and Rs2 connected to the differential input 108 of the differential amplifier 102. Thereby, the first resistive sensor element Rs1 can be connected to the first input 108_1 of the differential amplifier 102, wherein the second resistive sensor element Rs2 can be connected to the second input 108_2 of the differential amplifier 102.

Moreover, the first resistive sensor element Rs1 can be connected in series between the first input 108_1 of the differential amplifier 102 and a reference terminal (e.g. a ground terminal) 116, wherein the second resistive sensor element Rs2 can be connected in series between the second input 108_2 of the differential amplifier 102 and the reference terminal 116.

The differential amplifier 102 can comprise an input 114 for the common mode reference voltage $V_{CMREF}$. In addition, the differential amplifier 102 may comprise a first supply terminal for a first supply voltage (e.g., positive supply voltage Vdd) and a second supply terminal for a second supply voltage (e.g., negative supply voltage Vcc, or reference supply voltage, or ground).

In other words, embodiments of the present invention use a fully-differential amplifier 102 (A1) for resistive sensor 104 (Rs1 and Rs2) bias and amplification. The output common mode feedback of the amplifier 102 (A1) and the feedback resistors Rfb1 and Rfb2 set the bias point of the resistive sensor 104 (Rs1 and Rs2). The feedback resistors Rfb1 and Rfb2 are supposed to be typically (or almost, or substantially) equal and implemented with (almost, or substantially) the same physical needs. The sensor 104 is described in the following.

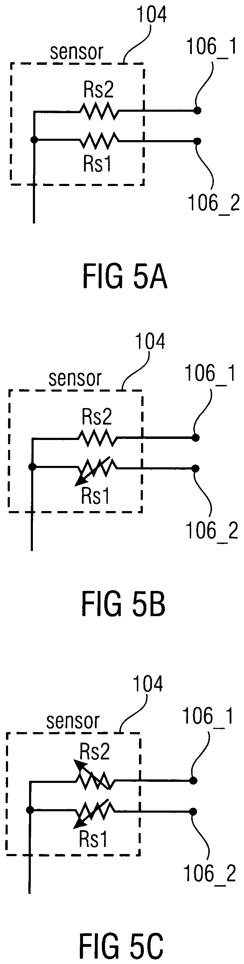

In the most general consideration, the resistive sensor 104 features two resistive sensor elements (or resistors), namely the first resistive sensor element Rs1 and the second resistive sensor element Rs2 that are physically similar and as a consequence typically equal when the sensor 104 experiences a neutral stimulation as shown in Fig. 5a. The first resistive sensor element (or resistive detector) Rs1 expresses a variation in resistance $\Delta Rs$ as a response to a given stimulation as shown in Fig. 5b, and its resistance expresses as follows:

$$R_{s1} = R_s + \Delta R_s \quad (\Omega) \tag{1}$$

In a preferred sensor 104 implementation, when the first resistive sensor element (or resistor) Rs1 experiences a variation in resistance as described in equation (1), then the second resistive sensor element (or resistor) Rs2 also experiences a variation in resistance (see Fig. 5c) as follows:

$$R_{s2} = R_s - \Delta R_s \quad (\Omega) \tag{2}$$

Supposing the sensor 104 shown in Fig. 4 is compliant with the preferred sensor configuration as described in Fig. 5c, and assuming that the differential mode voltage gain of the differential amplifier (A1) 102 is infinite and the error in output common mode regulation of the differential amplifier (A1) 102 is negligible, then the output voltage expresses:

$$V_{OUT} = \frac{2 \cdot \Delta R_s / R_s}{1 + \dfrac{R_s}{R_{fb}} \left[ 1 + \Delta R_s^2 / R_s^2 \right]} \cdot V_{CMREF} \quad (V) \tag{3}$$

Where Rfb is the nominal resistance of both feedback resistor Rfb1 and Rfb2. Supposing small variations in the sensor resistance i.e. $|\Delta R_s / R_s| \ll 1$, then expression (3) can be approximated by expression (4):

$$V_{OUT} \approx 2 \cdot \frac{1}{1 + \dfrac{R_s}{R_{fb}}} \cdot \left( \Delta R_s / R_s - \frac{\Delta R_s^3 / R_s^3}{1 + \dfrac{R_{fb}}{R_s}} \right) \cdot V_{CMREF} \quad (V) \tag{4}$$

In expression (4), it can be noted that if $R_{fb} \gg R_s$, then (first) the output voltage becomes independent of $R_{fb}$, and (second) the nonlinear term $(\Delta R_s / R_s)^3$ is decreased, thus the linearity of the proposed sensor arrangement 100 is improved.

Thus, supposing the sensor signal is converted into a digital word stream afterwards by an analog-to-digital converter (ADC), a ratiometrically compensated sensor system can be implemented, by using an ADC reference voltage which is a scaled version of the common mode reference voltage $V_{CMREF}$.

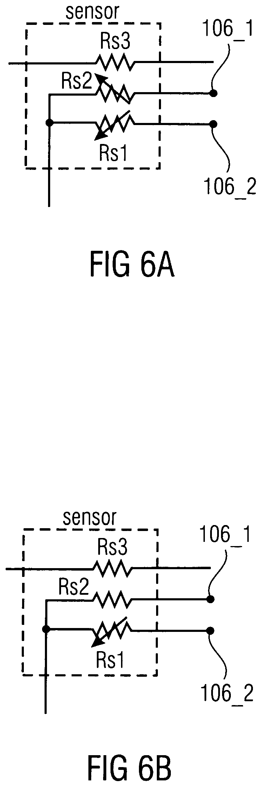

If the condition $R_{fb} \gg R_s$ is not met, then the output voltage $V_{OUT}$ exhibits a significant correlation with the $R_s / R_{fb}$ ratio. An optional compensation subsystem is described in the following. This compensation subsystem requires a sensor configuration that implements a reference resistive sensor element (third resistor) $R_{s3}$ that is physically equivalent to the two other resistive sensor elements (or resistors) $R_{s1}$ and $R_{s2}$ but does not implement the $\Delta Rs$ variation (see Figs. 6a and 6b).

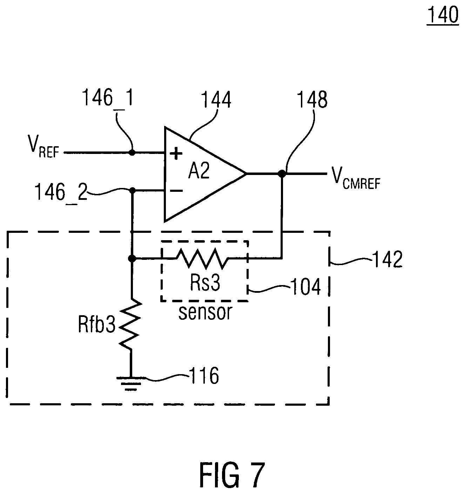

Fig. 7 shows a schematic of a common mode reference voltage provider 114 configured to provide a common mode reference voltage $V_{CMREF}$ for the differential amplifier 102. As shown in Fig. 7, the common mode reference voltage provider 140 can be configured to provide the common mode reference voltage $V_{CMREF}$ for the differential amplifier 102 using a reference resistor network 142 comprising a reference feedback resistor Rfb3 and a reference resistive sensor element (or reference resistor) Rs3. The reference feedback resistor Rfb3 can comprise a resistance value that is equivalent to the resistance value(s) of the feedback resistor(s) Rfb1 and Rfb2. The reference resistive sensor element Rs3 can comprise a resistance value that is equivalent to the resistance value(s) of the resistive sensor element(s) Rs1 and Rs2.

As shown in Fig. 7, the common mode reference voltage provider 140 can comprise a (single-ended) amplifier 144 having a first input 146_1 (e.g. a non-inverting input) for a reference voltage $V_{REF}$, a second input 146_2 (e.g. an inverting input) and an output 148 for providing the common mode reference voltage $V_{CMREF}$. Thereby, the reference resistive sensor element Rs3 can be connected in series between the second input 146_2 and the output 148 of the amplifier 144, wherein the reference feedback resistor Rfb3 can be connected in series between the second input 146_2 of the amplifier 144 and a reference terminal 116 (e.g. ground terminal).

In other words, the option proposed here is a bias compensation subsystem 140 that generates a common mode reference voltage $V_{CMREF}$, e.g., for the input 114 (see Fig. 4), for sensor bias with compensation property (see Fig. 7). This bias compensation subsystem 140 is implemented with a single-ended amplifier (A2) 144 that features in its feedback network the reference feedback resistor Rfb3. The reference feedback resistor Rfb3 can be physically equivalent to the feedback resistors Rfb1 and Rfb2. It can be noticed that the resistive sensor elements (or resistors) Rs1, Rs2 and Rs3, respectively the feedback resistors Rfb1, Rfb2 and Rfb3 have the same bias conditions.

Supposing the resistive sensor elements (or resistors of the sensor 104) Rs1, Rs2 and Rs3 are built with a given technology, and the resistors Rfb1 and Rfb2 for amplifier feedback are built with different techniques and/or are operated in different conditions (e.g. at different temperature), this causes fluctuations in the output voltage of the system 100 described in (Fig. 4). If the condition $R_{fb} \gg R_s$ is not met, then the associated gain error (see expression (4)) can exceed the specifications. The here described compensation system 140 (see Fig. 7) cancels the effects on the sensor bias point of a global error affecting equally the feedback resistors Rfb1, Rfb2 and Rfb3.

Supposing that the differential voltage gain of the amplifier 144 (A2) is infinite, the voltage generated by the bias compensation subsystem 140 (Fig. 7, $V_{CMREF}$) expresses:

$$V_{CMREF} = \left(1 + \frac{R_s}{R_{fb}}\right) \cdot V_{REF} \quad (V) \tag{5}$$

Supposing the voltage $V_{CMREF}$ generated by the bias compensation subsystem 140 (Fig. 7) is used as common mode reference voltage for the proposed sensor bias and readout system (Fig. 4, $V_{CMREF}$), then the output voltage given in expression (4) rewrites:

$$V_{OUT} \approx 2 \cdot \left( \Delta R_s / R_s - \frac{\Delta R_s^3 / R_s^3}{1 + \frac{R_{fb}}{R_s}} \right) \cdot V_{REF} \quad (V) \tag{6}$$

Consequently, the $\Delta R_s$ variation in the sensor resistance results in variations of $V_{OUT}$ that are independent of the values of the feedback resistors Rfb1 and Rfb2. Thus, supposing the sensor signal is converted into a digital word stream afterwards by an analog-to-digital converter, a ratiometrically compensated sensor system can be implemented by using an ADC reference voltage which is a scaled version of the $V_{REF}$ voltage.

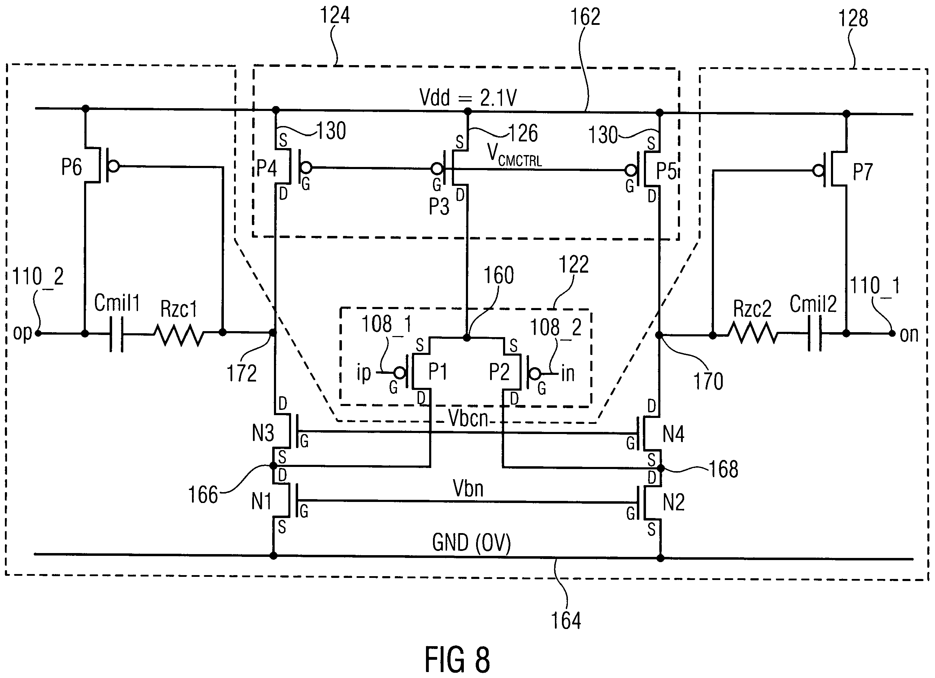

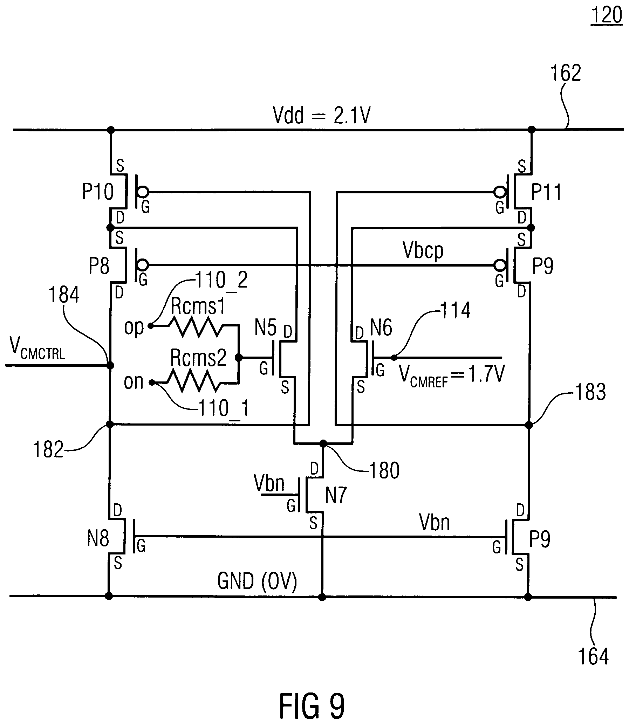

Fig. 8 shows an electrical schematic of the differential amplifier 102 according to an embodiment of the present invention. The differential amplifier 102 comprises the differential amplifier core 122, the bias circuit 124, the output circuit 128 and the output common mode control 120 (see Fig. 9). In other words, the differential amplifier 102 comprises a fully-differential core (two-stages, Miller compensated).

The differential amplifier core 122 comprises a first PMOS transistor P1 and a second PMOS transistor P2. A gate of the first PMOS transistor P1 can be connected to the first input terminal 108_1 (ip, non-inverting input) of the differential amplifier 102, wherein a gate of the second PMOS transistor P2 can be connected to the second input terminal 108_2 (in, inverting input) of the differential amplifier 102.

Moreover, a channel contact (e.g., source contact) of the first PMOS transistor P1 and a channel contact (e.g., source contact) of the second PMOS transistor P2 can be connected to a common supply node 160 of the differential amplifier core 122.

The bias circuit 124 can comprise a third PMOS transistor P3, a fourth PMOS transistor P4 and a fifth PMOS transistor P5. Gates of the third PMOS transistor P3, the fourth PMOS transistor P4 and the fifth PMOS transistor P5 can be connected to the output common mode control 120 (see Fig 9), wherein the output common mode control 120 can be configured to provide the common mode control voltage $V_{CMCTRL}$ for the gates of the third PMOS transistor P3, the fourth PMOS transistor P4 and the fifth PMOS transistor P5. Channel contacts of the third PMOS transistor P3, the fourth PMOS transistor P4 and the fifth PMOS transistor P5 can be connected to a positive supply node or rail 162 of the differential amplifier 102. For example, a positive supply voltage of Vdd = 2.1 V can be present at the positive supply node or rail 162 of the differential amplifier 102.

Thus, the third PMOS transistor P3 can be configured to provide a bias current 126 for the differential amplifier core 122 based on the common mode control voltage $V_{CMCTRL}$, wherein the fourth PMOS transistor P4 and the fifth PMOS transistor P5 can be configured to provide bias currents 130 for the output circuit 128, in dependence on the common mode control voltage $V_{CMCTRL}$ provided by the output common mode control 120.

Hence, the output common mode control 120 (see Fig. 9) can be configured to control or regulate the bias current 126 provided by the bias circuit 124 for the differential amplifier core 122 by means of the common mode control voltage $V_{CMCTRL}$. Further, the output common mode control 120 (see Fig. 9) can be configured to control or regulate the bias currents 130 provided by the bias circuit 124 for the output circuit 128 by means of the common mode control voltage $V_{CMCTRL}$.

The output circuit 128 of the differential amplifier 102 can comprise a first NMOS transistor N1, a second NMOS transistor N2, a third NMOS transistor N3 and a fourth NMOS transistor N4.

Channels of the fourth PMOS transistor P4, the third NMOS transistor N3 and the first NMOS transistor N1 can be connected in series between the positive supply node or rail 162 and a reference supply node or rail 164 (e.g. ground array).

For example, the channels of the fourth PMOS transistor P4, the third NMOS transistor N3 and the first NMOS transistor N1 can be connected in series between the positive supply node or rail 162 and the reference supply node or rail 164 such that a source contact of the fourth PMOS transistor P4 is connected to the positive supply node or rail 162, wherein a drain contact of the fourth PMOS transistor P4 is connected to a drain contact of the third NMOS transistor N3, wherein a source contact of the third NMOS transistor N3 is connected to a drain contact of the first NMOS transistor N1, and wherein a source contact of the first NMOS transistor N1 is connected to the reference supply node or rail 164.

Further, channels of the fifth PMOS transistor P5, the fourth NMOS transistor N4 and the second NMOS transistor N2 can be connected in series between the positive supply node or rail 162 and the reference node or rail 164.

For example, the channels of the fifth PMOS transistor P5, the fourth NMOS transistor N4 and the second NMOS transistor N2 can be connected in series between the positive supply node or rail 162 and the reference node or rail 164 such that a source contact of the fifth PMOS transistor P5 is connected to the positive supply node or rail 162, wherein a drain contact of the fifth PMOS transistor P5 is connected to a drain contact of the fourth NMOS transistor N4, wherein a source contact of the fourth NMOS transistor N4 is connected to a drain contact of the second NMOS transistor N2, and wherein a source contact of the second NMOS transistor N2 is connected to the reference supply node or rail 164.

Gate contacts of the third NMOS transistor N3 and the fourth NMOS transistor N4 can be controlled by a bias voltage of NMOS cascodes Vbcn, wherein gates of the first NMOS transistor N1 and the second NMOS transistor N2 can be controlled by a bias voltage of NMOS loads Vbn.

Moreover, a channel contact of the first PMOS transistor P1 can be connected to a node 166 that is connected in series between the first NMOS transistor N1 and the third NMOS transistor N3. In other words, a channel of the first PMOS transistor P1 can be connected in series between the common supply node 160 of the differential amplifier core 122 and the node 166 that is connected in series between first NMOS transistor N1 and the third NMOS transistor N3. In other words, a source contact of the first PMOS transistor P1 can be connected to the common supply node 160 of the differential amplifier core 122, wherein a drain contact of the first PMOS transistor P1 can be connected to the source contact of the third NMOS transistor N3 and/or to the drain contact of the first NMOS transistor N1.

Similarly, a channel contact of the second PMOS transistor P2 can be connected to a node 168 that is connected in series between the second NMOS transistor N2 and the fourth NMOS transistor N4. In other words, a channel of the second PMOS transistor P2 can be connected in series between the common supply node 160 of the differential amplifier core 122 and the node 168 that is connected in series between the second NMOS transistor N2 and the fourth NMOS transistor N4. In other words, a source contact of the second PMOS transistor P2 can be connected to the common supply node 160 of the differential amplifier core 122, wherein a drain contact of the second PMOS transistor P2 can be connected to the source contact of the fourth NMOS transistor N4 and/ or to the drain contact of the second NMOS transistor N2.

Further, the output circuit 128 of the differential amplifier 102 can comprise a series connection of a first Miller capacitor Cmil1 and a first output resistor Rzc1 connected in series between the second output 110_2 of the differential amplifier 102 and a node 172 that is connected between the fourth PMOS transistor P4 and the third NMOS transistor N3. In addition, the output circuit 128 of the differential amplifier 102 can comprise a sixth PMOS transistor P6, wherein a channel of the sixth PMOS transistor P6 can be connected in series between the positive supply node or rail 162 and the second output 110_2 of the differential amplifier 102, and wherein a gate of the sixth PMOS transistor P6 can be connected to the node 172 that is connected between the drain contacts of the fourth PMOS transistor P4 and the third NMOS transistor N3.

Similarly, the output circuit 128 of the differential amplifier 102 can comprise a series connection of a second output resistor Rzc2 and a second Miller capacitor Cmil2 connected between the first output 110_1 of the differential amplifier 102 and a node 170 that is connected between the drain contacts of the fifth PMOS transistor P5 and the fourth NMOS transistor N4. In addition, the output circuit 128 of the differential amplifier 102 can comprise a seventh PMOS transistor P7, wherein a channel of a seventh PMOS transistor P7 is connected in series between the positive supply node or rail 162 and the first output 110_1 of the differential amplifier 102, and wherein a gate of the seventh PMOS transistor P7 is connected to the node 170 that is connected between the fifth PMOS transistor P5 and the fourth NMOS transistor N4.

Fig. 9 shows a schematic of the output common mode control 120 according to an embodiment of the present invention.

The output common mode control 120 can comprise a fifth NMOS transistor N5, a sixth NMOS transistor N6 and a seventh NMOS transistor N7. Channel contacts of the fifth NMOS transistor N5 and the sixth NMOS transistor N6 can be connected to a common node 180, wherein a channel of the seventh NMOS transistor N7 can be connected in series between the common node 180 and the reference node or rail 164 of the differential amplifier 102.

Further, the output common mode control 120 can comprise an eighth NMOS transistor N8, an eighth PMOS transistor P8 and a tenth PMOS transistor P10. Channels of the tenth PMOS transistor P10, eighth PMOS transistor P8 and eighth NMOS transistor N8 can be connected in series between the positive supply node or rail 162 and the reference supply node or rail 164.

For example, the channels of the tenth PMOS transistor P10, eighth PMOS transistor P8 and eighth NMOS transistor N8 can be connected in series between the positive supply node or rail 162 and the reference supply node or rail 164 such that a source contact of the tenth PMOS transistor P10 is connected to the positive supply node or rail 162, wherein a drain contact of the tenth PMOS transistor P10 is connected to a source contact of the eighth PMOS transistor P8, wherein a drain contact of the eighth PMOS transistor P8 is connected to a drain contact of the eighth NMOS transistor N8, wherein a source contact of the eighth NMOS transistor N8 is connected to the reference supply node or rail 164.

Further, the common mode control 120 can comprise a ninth NMOS transistor N9, a ninth PMOS transistor P9 and an eleventh PMOS transistor P11. Channels of the eleventh PMOS transistor P11, the ninth PMOS transistor P9 and the ninth NMOS transistor N9 can be connected in series between the positive supply node or rail 162 and the reference node or rail 164 of the differential amplifier 102.

For example, the channels of the eleventh PMOS transistor P11, the ninth PMOS transistor P9 and the ninth NMOS transistor N9 can be connected in series between the positive supply node or rail 162 and the reference supply node or rail 164 such that a source contact of the eleventh PMOS transistor P11 is connected to the positive supply node or rail 162, wherein a drain contact of the eleventh PMOS transistor P11 is connected to a source contact of the ninth PMOS transistor P9, wherein a drain contact of the ninth PMOS transistor P9 is connected to a drain contact of the ninth NMOS transistor N9, wherein a source contact of the ninth NMOS transistor N9 is connected to the reference supply node or rail 164.

Gates of the eighth NMOS transistor N8 and the ninth NMOS transistor N9 can be controlled by a bias voltage of NMOS loads Vbn. Gates of the eighth PMOS transistor P8 and the ninth PMOS transistor P9 can be controlled by a bias voltage of PMOS cascodes Vbcp. A gate of the seventh NMOS transistor N7 can be controlled by a bias voltage of NMOS loads Vbn.

Further, a gate of the tenth PMOS transistor P10 can be connected to a node 182 that is connected in series between channel contacts of the eighth PMOS transistor P8 and the eighth NMOS transistor N8. In other words, the gate of the tenth PMOS transistor P10 can be connected to the drain of the eighth PMOS transistor P8 and/or to the drain contact of the eighth NMOS transistor N8.

Similarly, a gate of the eleventh PMOS transistor P11 can be connected to a node 183 that is connected in series to channel contacts of the ninth PMOS transistor P9 and the ninth NMOS transistor N9. In other words, the gate of the eleventh PMOS transistor P11 can be connected to the drain of the ninth PMOS transistor P9 and/or to the drain of the ninth NMOS transistor N9.

As shown in Fig. 9, the common mode control 120 can comprise an output 184 for providing the common mode control voltage $V_{CMCTRL}$ for the bias circuit 124 of the differential amplifier 102. The output 184 of the output common mode control 120 can be connected in series between channel contacts of the eighth PMOS transistor P8 and the eighth NMOS transistor N8. In other words, the output 184 of the output common mode control 120 can be connected in series between the drain contact of the eighth PMOS transistor P8 and the drain contact of the eighth NMOS transistor N8.

As already mentioned, the output common mode control 120 can be configured to control or regulate the bias current 126 provided by the bias circuit 124 for the differential amplifier core 122 and/or the bias currents 130 provided by the bias circuit 124 for the output circuit 128 based on a common mode reference voltage $V_{CMREF}$. For this purpose, the output common mode control 120 can comprise an input 114 for the common mode reference voltage $V_{CMREF}$. The input 114 of the output common mode control 120 can be connected to the gate of the sixth NMOS transistor N6.

Further, the output common mode control 120 can be configured to control or regulate the bias current 126 provided by the bias circuit 124 for the differential amplifier core 122 and/or the bias currents 130 provided by the bias circuit 124 for the output circuit 128 based on the average voltage present between the differential output nodes 110_1 and 110_2 of the differential amplifier 102. For that purpose, the gate of the fifth NMOS transistor N5 can be controlled by the common mode output voltage between the nodes 110_1 and 110_2. Further, the output common mode control 120 can comprise a resistor network (e.g. comprising the resistors Rcmsl and Rcms2) for averaging the output voltages $V_{OUT2}$ and $V_{OUT1}$ provided at the differential output 110 of the differential amplifier 102, and to control or regulate the bias currents 126 and 130 provided by the bias circuit 124 using the averaged voltages.

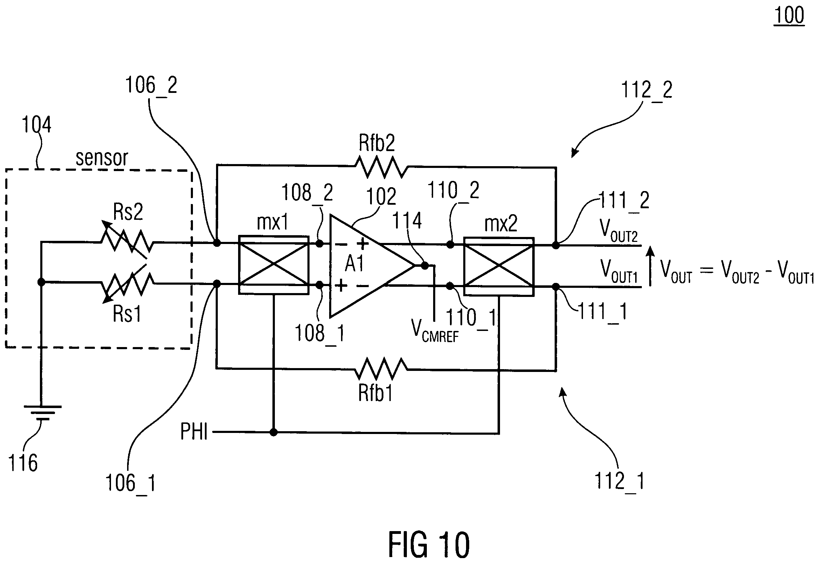

Fig. 10 shows a schematic of the sensor arrangement 100 according to a further embodiment of the present invention. In contrast to Fig. 4, the sensor arrangement 100 can further comprise a first multiplexer mx1 and a second multiplexer mx2. The first multiplexer mx1 can be connected in series between the terminals 106_1 and 106_2 of the sensor 104 and the input terminals 108_1 and 108_2 of the differential input 108 of the differential amplifier 102. The second multiplexer mx2 can be connected in series between the output terminals 110_1 and 110_2 of the differential output 110 of the differential amplifier 102 and output terminals 111_1 and 111_2 of the sensor arrangement 100. Thereby, the first feedback resistor Rfb1 can be connected in series between the first terminal 106_1 of the sensor 104 and the first output terminal 111_1 of the sensor arrangement 100, in order to provide the first feedback path 112_1, wherein the second feedback resistor Rfb2 can be connected in series between the second terminal 106_2 of the sensor 104 and the second output terminal 111_1 of the sensor arrangement 100, in order to provide the second feedback path 112_2.

In other words, the proposed system 100 includes as an option a low-frequency noise cancelling function in the form of two fully-differential mixers mx1 and mx2. The second mixer mx2 modulates the low-frequency noise of the differential amplifier 120 (A1) with a square-wave carrier of (+1,-1) amplitude synchronized by (PHI). The first mixer mx1 corrects the feedback polarity change induced by the second mixer mx2 to maintain the differential amplifier 120 (A1) in a negative feedback configuration. The output signal $V_{OUT}$ can be directly low-pass filtered to cancel the modulated noise of the differential amplifier(A1).

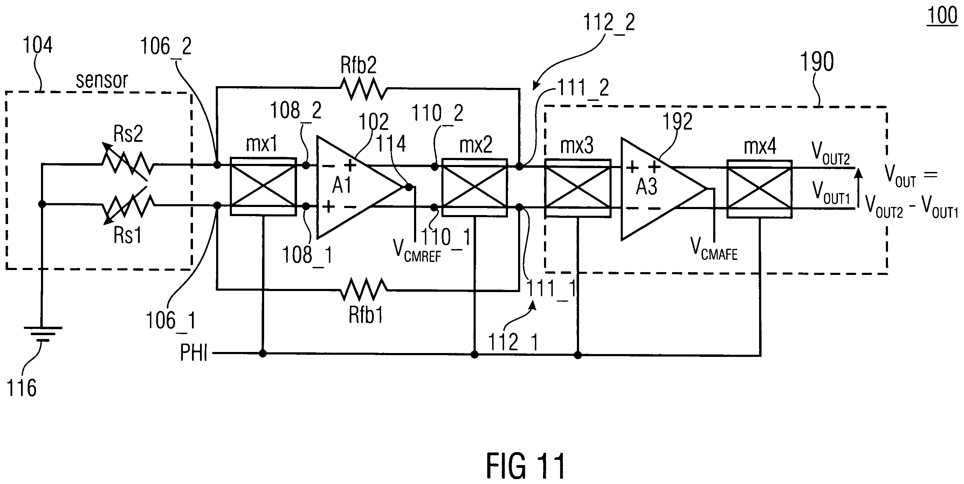

Notice about the common mode reference voltage $V_{CMREF}$ and the optimal use of the available analog voltage swing as defined by the supply rails: in the proposed sensor arrangement 100, the output differential mode voltage of the differential amplifier 102 (A1) is proportional to the output common mode voltage of the differential amplifier 102 (A1). Considering formula (4) with a quite large $\Delta Rs/Rs$ of five percent, the differential swing at the output of the differential amplifier 102 (A1) is expected to be in the range of one tenth of the common mode reference voltage $V_{CMREF}$ at the most. Thus, it is in practice possible to maximize the gain of the proposed sensor arrangement 100 by increasing the common mode reference voltage $V_{CMREF}$ close to the positive supply rail 162, thanks to the limited differential output swing of the differential amplifier 102 (A1) given by formula (4). This is of interest in a low-noise sensor design, since a higher gain in the first stage (i.e. proposed sensor arrangement 100) reduces the noise constraints on the following elements in the analog/mixed-signal front-end. As a consequence an optimization criterion for the application of the proposed sensor arrangement 100 to a low-noise sensor is to maximize the common mode reference voltage $V_{CMREF}$. Quite the contrary, in the following stages of the analog-front-end, it is desirable to use the full voltage swing available between the supply rails to maximize the power efficiency. This second optimization criterion is not compatible with a common mode close to the positive supply rail 162 i.e. with the optimization criterion of the proposed sensor arrangement 100. A first solution to this problem is to use as a second stage a fully-differential amplifier 190 with output common mode feedback as described in Fig. 11: the output common mode feedback of this second amplifier shifts the common mode of the signal to the (VCMAFE) level desired in the following blocs of the analog front-end. A second solution is to use a low-dropout regulator (LDO) to generate a voltage for the positive supply rail 162 of the proposed sensor arrangement 100 lower than the supply voltage of the following stage 190. This can be used to provide the proposed sensor arrangement 100 with a stable supply voltage free from parasitic transient voltages. For example, the main supply voltage i.e. the supply voltage of the second amplifier 190 may be 2.1V, the voltage of the positive supply rail 162 of the fully-differential amplifier 102 may be 1.6V regulated by the LDO, and the (VCMREF) voltage may be 1.1V and could thus be the same as (VCMAFE).

Fig. 11 shows a schematic of the sensor arrangement 100 shown in Fig. 10 and of a second amplifier stage 190 connected downstream to the sensor arrangement 100, according to an embodiment of the present invention. The second amplifier stage 190 comprises a third multiplexer mx3, a second differential amplifier 192 and a fourth multiplexer mx4. The third multiplexer mx3, the second differential amplifier 192 and the fourth multiplexer mx4 are connected in series such that the third multiplexer mx3 is connected to the output terminal 111_1 and 111_2 of the sensor arrangement 100.

In other words, in practice it is also useful to use chopping in this second stage 190, to also reject its low-frequency noise and offset, as proposed in Fig. 11.

In embodiments, and in contrast to the common sensor readout and bias system shown in Fig. 1, the common mode reference voltage $V_{CMREF}$ of the proposed sensor arrangement 100 is better set close to the supply voltage. Assuming that the typical input-referred offset of an amplifier is in the range of 10 mV, this offset corresponds to a 10% uncertainty in sensor bias with the system proposed in Fig. 1, whereas the proposed sensor arrangement 100 with a common mode reference voltage equal to 1 V ($V_{CMREF}$ = 1V) achieves a sensor bias uncertainty of 1%. Besides the variations with temperature and aging of this amplifier offset can induce significant errors of the sensor response, as a result from the associated variations in the bias point. In Fig. 1, a chopping scheme had to be implemented in the amplifier 10 (Abias) so as to compensate for the sensor bias uncertainty associated with the offset of the amplifier 10 (Abias), this additional complication may not be required with the proposed sensor arrangement 100 supposing that the common mode reference voltage is greater than 1 V ($V_{CMREF}$ > 1V). Another difficulty is associated with the need to generate a floating reference voltage $V_{CMREF2}$, and a regulated common mode reference voltage $V_{CM}$ with current-sink capability.

Supposing the complete sensor readout system includes an analog-to-digital conversion of the sensor signal, the proposed system for sensor bias and readout allows for the implementation of the ratiometric compensation principle. In a ratiometric system, the output voltage of the signal source is proportional to a reference voltage, so that if the signal is digitized by an analog-to-digital converter that uses the same reference voltage (or a homothetic scaling of this reference) then the digitized signal is independent of the variations in the reference voltage. This relaxes the constraint on the reference voltage precision hence the overall system cost since reference trimming is simplified.

Supposing that the sensor and the electronic system are not implemented with the same technology, or are operated in different conditions (e.g. temperature) then the effects of the variations in electronic circuit properties on the output signal voltage are rejected by the proposed invention. The effect of the variations in the nominal sensor resistance on the sensor bias point is also rejected.

System power consumption is expected to be decreased since the sensor bias current is reused to provide signal amplification.

System power consumption can also be possibly reduced through specific fully-differential amplifier design. To achieve a high-enough gain, a two-stage configuration is in most cases preferable given the resistive feedback scheme and associated low-voltage-gain in the output stage. Since a low input-referred noise is desirable, a high transconductance is expected in the input-stage to reduce the input-referred 4kTR noise. Then, to achieve an effective Miller compensation of the two-stage amplifier, an even higher transconductance is expected from the output stage. Interestingly, the sensor bias current also serves as a bias current for the output stage of the amplifier, thus making it possible to achieve a high transconductance in the output stage with no additional consumption. This property helps to design a stable yet low-power 2-stage amplifier.

To summarize, the sensor bias current: 1) provides signal gain and 2) interestingly biases the output stage of the amplifier which enables the design of a 2-stage implementation with reduced power consumption.

Only one amplifier contributes to the sensor noise, thus the proposed system is adequate for a low-noise sensor readout system. Besides the system is compatible with the low frequency-noise-cancellation techniques, thus it is suitable for a low-noise, low-pass sensor system i.e. a sensor requiring a high DC precision.

The actual sensor bias voltage can be very low. This allows for reductions in the power dissipation of the sensor. For example this can help to enhance the reliability of a given sensor. It can also help to meet given security requirements, for example in environments with explosion hazard.

Despite the low sensor bias voltage, the reference voltage can be high-enough so that errors in the bias reference have a negligible effect on the sensor bias-point. This particularity allows for relaxed constraints on the offset and noise of the bias voltage generator, with expected reductions in power consumption and circuit complexity. If a ratiometric sensor system is implemented, then the ADC reference voltage and the reference voltage for sensor bias can be in the same order of magnitude even if the actual sensor bias voltage is much lower.

The sensor bias-point is independent of the supply voltage variations.

The output is a differential voltage which provides immunity to the common mode disturbances.

The system is only based on closed-loops, both for the bias and the amplification, thus it achieves enhanced precision, provided the loop gains are high-enough.

Moreover, embodiments provide a compact system, i.e., only one or two operational amplifier(s) achieve precision sensor bias and low-noise signal amplification. Additional signal amplification required before analog-to-digital conversion can be performed, yet noise performance can be lower in the corresponding extra amplifiers thanks to the gain of the proposed sensor arrangement.

**Claims**

1. Sensor arrangement (100), comprising:

   a differential amplifier (102) comprising a differential input (108) having a first input terminal (108_1) and a second input terminal (108_2) a differential output (110) having a first output terminal (110_1) and a second output terminal (110_2) and a common-mode reference voltage input (114);
   a sensor (104) connected to the differential input (108) of the differential amplifier (102), wherein the sensor (104) comprises two resistive sensor elements (Rs1, Rs2), wherein a first resistive sensor element (Rs1) of the two resistive sensor elements (Rs1, Rs2) is connected to the first input (108_1) of the differential amplifier (102), wherein a second resistive sensor element (Rs2) of the two resistive sensor elements (Rs1, Rs2) is connected to the second input (108_2) of the differential amplifier (102);
   a differential feedback path (112) comprising a first feedback path (112_1) from the first output terminal (110_1) of the differential output (110) to the first input terminal (108_1) of the differential input (108) and a second feedback path (112_2) from the second output (110_2) of the differential output (110) to the second input (108_2) of the differential input (108) of the differential amplifier (102), wherein the differential feedback path (112) comprises two feedback resistors (Rfb1; Rfb2) equal in value, wherein the first feedback path (112_1) comprises the first feedback resistor (Rfb1), and wherein the second feedback path (112_2) comprises the second feedback resistor (Rfb2);
   wherein the differential amplifier (102) is configured to keep the average of the voltages between, first, the second output terminal (110_2) of the differential amplifier (102) and the reference terminal (116) of the sensor (104), and second, the first output terminal (110_1) of the differential amplifier (102) and the reference terminal (116) of the sensor (104), equal to a reference voltage via a common-mode feedback, thereby providing the sensor resistors (Rs1, Rs2) with a bias current via the first and second output terminals (110_1, 110_2) of the differential amplifier (102) and the first and second feedback resistors (Rfb1, Rfb2); and
   wherein the differential amplifier (102) is configured to keep the voltage difference between the first and second input terminals (108_1, 108_2) of the differential amplifier (102) equal to zero via a differential-mode feedback executed by the first and second output terminals (110_1, 110_2) of the differential amplifier (102) via the first and second feedback resistors (Rfb1, Rfb2), thereby providing with sensor signal amplification and conversion into an output voltage ($V_{OUT}$, $V_{OUT2}$-$V_{OUT1}$) present between the first and second output terminals (110_1, 110_2).

2. Sensor arrangement (100) according to claim 1, wherein the differential amplifier (102) comprises an output common mode control (120), a differential amplifier core (122), an output circuit (128) and a bias circuit (124);
   wherein the differential amplifier core (122) is connected to the differential input (108), wherein the output circuit (128) is connected to the differential amplifier core (122) and to the differential output (110), wherein the bias circuit (124) is connected to the differential amplifier core (122) and to the output circuit (128), wherein the common mode control (120) is connected to the differential output (110) of the differential amplifier (102);
   wherein the output common mode control (120) is configured to control or regulate a common mode output voltage of the differential amplifier (102) based on the common mode reference voltage ($V_{CMREF}$);
   wherein the output common mode control (120) is configured to control or regulate a bias current (126) provided by the bias circuit (124) for the differential amplifier core (122) based on the common mode reference voltage ($V_{CMREF}$);
   wherein the output common mode control (120) is configured to control or regulate a bias current (130) provided by the bias circuit (124) for the output circuit (128) based on the common mode reference voltage ($V_{CMREF}$);
   wherein the output common mode control (120) is configured to control or regulate the bias current (126, 130) provided by the bias circuit (124) further based on the output voltages ($V_{OUT1}$, $V_{OUT2}$) provided at the differential output (110) of the differential amplifier (102);
   wherein the output common mode control (120) is configured to average the output voltages ($V_{OUT1}$, $V_{OUT2}$) provided at the differential output (110) of the differential amplifier (102) using a resistor network, and to control or regulate the bias current (126, 130) provided by the bias circuit (124) using the averaged voltages;
   wherein the output circuit (128) is configured to provide the differential mode output voltage ($V_{OUT}$) based on bias currents (130) provided by the bias circuit (124) and currents provided by the differential amplifier core (122), thus providing the differential amplifier (112) with a high differential-gain mode and a high-precision output common-mode voltage regulation resulting in an improved precision and linearity of the sensor arrangement (100).

3. Sensor arrangement (100) according to claim 1, wherein resistance values of the feedback resistors (Rfb1, Rfb2) are at least by a factor of ten greater than resistance values of the resistive sensor elements (Rs1, Rs2) such that the output voltage ($V_{OUT2}$ - $V_{out1}$) provided at the differential output (110) of the differential amplifier (102) is independent on the value of the feedback resistors (Rfb1, Rfb2) while the common mode reference voltage ($V_{CMREF}$) is a user-defined voltage.

4. Sensor arrangement (100) according to claim 1, wherein resistance values of the feedback resistors (Rfb1, Rfb2) are less than a factor of ten greater than resistance values of the resistive sensor elements (Rs1, Rs2) such that the output voltage ($V_{OUT2}$ - $V_{OUT1}$) provided at the differential output (110) of the differential amplifier (102) depends on the value of the feedback resistors (Rfb1, Rfb2) in case the common mode reference voltage ($V_{CMREF}$) is a user-defined voltage;

   wherein a bias compensation subsystem (140) is configured to provide the common mode reference voltage ($V_{CMREF}$) for the differential amplifier (102) using a user-defined reference voltage ($V_{REF}$) and a reference resistor network (142) comprising a reference feedback resistor (Rfb3) and a reference resistive sensor element (Rs3), wherein the reference feedback resistor (Rfb3) comprises a resistance value that is equivalent to the resistance values of the feedback resistors (Rfb1, Rfb2), and wherein the reference resistive sensor element (Rs3) comprises a resistance value that is equivalent to the resistance value of the resistive sensor elements (Rs1, Rs2), thus providing the input (114) of the differential amplifier (102) with the common mode reference voltage ($V_{CMREF}$) having self-compensation properties so that the output voltage ($V_{OUT2}$ - $V_{out1}$) provided at the differential output (110) of the differential amplifier (102) is independent of the value of resistors (Rfb1, Rfb2).

5. Sensor arrangement (100) according to claim 1, wherein the first feedback resistor (Rfb1) of the two feedback resistors (Rfb1, Rfb2) and the first resistive sensor element (Rs1) of the two resistive sensor elements (Rs1, Rs2) are connected in series between the first output terminal (110_1) of the differential output (110) of the differential amplifier (102) and the reference terminal (116);

   wherein the second feedback resistor (Rfb2) of the two feedback resistors (Rfb1; Rfb2) and the second resistive sensor element (Rs2) of the two resistive sensor elements (Rs1, Rs2) are connected in series between the second output terminal (110_2) of the differential output (110) of the differential amplifier (102) and the reference terminal (116); and

   wherein the output circuit (128) of the differential amplifier (102) comprises a sixth PMOS transistor (P6) and a seventh PMOS transistor (P7), wherein a channel of the sixth PMOS transistor (P6) is connected between a positive supply node (162) of the differential amplifier (102) and the second output (110_2) of the differential amplifier 102, and wherein a channel of the seventh PMOS transistor (P7) is connected between the positive supply node (162) of the differential amplifier (102) and the first output (110_1) of the differential amplifier (102), thereby biasing the transistors (P7) and (P6) of the amplifier (102) and the two resistive sensor elements (Rs1, Rs2) with the same current thus reducing the power consumption of the sensor arrangement (100).

6. Method for operating the sensor arrangement according to claim 1, wherein the method comprises providing a bias for the sensor based on the common-mode reference voltage ($V_{CMREF}$) provided as a control reference for the output common-mode of the differential amplifier.

**Patentansprüche**

1. Sensoranordnung (100), die folgende Merkmale aufweist:

   einen Differenzverstärker (102), der einen Differenzeingang (108) mit einem ersten Eingangsanschluss (108_1) und einem zweiten Eingangsanschluss (108_2), einen Differenzausgang (110) mit einem ersten Ausgangsanschluss (110_1) und einem zweiten Ausgangsanschluss (110_2) und einen Gleichtaktreferenzspannungseingang (114) aufweist;

   einen Sensor (104), der mit dem Differenzeingang (108) des Differenzverstärkers (102) verbunden ist, wobei der Sensor (104) zwei resistive Sensorelemente (Rs1, Rs2) aufweist, wobei ein erstes resistives Sensorelement (Rs1) der zwei resistiven Sensorelemente (Rs1, Rs2) mit dem ersten Eingang (108_1) des Differenzverstärkers (102) verbunden ist, wobei ein zweites resistives Sensorelement (Rs2) der zwei resistiven Sensorelemente (Rs1, Rs2) mit dem zweiten Eingang (108_2) des Differenzverstärkers (102) verbunden ist;

   einen Differenzrückkopplungsweg (112), der einen ersten Rückkopplungsweg (112_1) von dem ersten Ausgangsanschluss (110_1) des Differenzausgangs (110) zu dem ersten Eingangsanschluss (108_1) des Differenzeingangs (108) und einem zweiten Rückkopplungsweg (112_2) von dem zweiten Ausgang (110_2) des Differenzausgangs (110) zu dem zweiten Eingang (108_2) des Differenzeingangs (108) des Differenzverstärkers (102) aufweist, wobei der Differenzrückkopplungsweg (112) zwei Rückkopplungswiderstände (Rfb1; Rfb2) mit gleichem Wert aufweist, wobei der erste Rückkopplungsweg (112_1) den ersten Rückkopplungswiderstand (Rfb1) aufweist und wobei der zweite Rückkopplungsweg (112_2) den zweiten Rückkopplungswiderstand (Rfb2) aufweist;

wobei der Differenzverstärker (102) konfiguriert ist, um den Durchschnitt der Spannungen zwischen erstens dem zweiten Ausgangsanschluss (110_2) des Differenzverstärkers (102) und dem Referenzanschluss (116) des Sensors (104) und zweitens dem ersten Ausgangsanschluss (110_1) des Differenzverstärkers (102) und dem Referenzanschluss (116) des Sensors (104) über eine Gleichtaktrücckopplung gleich einer Referenzspannung zu halten, wodurch den Sensorwiderständen (Rs1, Rs2) über den ersten und zweiten Ausgangsanschluss (110_1, 110_2) des Differenzverstärkers (102) und den ersten und zweiten Rückkopplungswiderstand (Rfb1, Rfb2) ein Biasstrom bereitgestellt wird; und

wobei der Differenzverstärker (102) konfiguriert ist, um die Spannungsdifferenz zwischen dem ersten und zweiten Eingangsanschluss (108_1, 108_2) des Differenzverstärkers (102) über eine Gegentaktrückkopplung gleich null zu halten, die durch den ersten und zweiten Ausgangsanschluss (110_1, 110_2) des Differenzverstärkers (102) über den ersten und zweiten Rückkopplungswiderstand (Rfb1, Rfb2) ausgeführt wird, wodurch Sensorsignalverstärkung und -umwandlung in eine Ausgangsspannung ($V_{OUT}$, $V_{OUT2}$-$V_{OUT1}$) bereitgestellt wird, die zwischen dem ersten und zweiten Ausgangsanschluss (110_1, 110_2) vorliegt.

2. Sensoranordnung (100) gemäß Anspruch 1, bei der der Differenzverstärker (102) eine Ausgangsgleichtaktsteuerung (120), einen Differenzverstärkerkern (122), eine Ausgangsschaltung (128) und eine Vorspannungsschaltung (124) aufweist;

wobei der Differenzverstärkerkern (122) mit dem Differenzeingang (108) verbunden ist, wobei die Ausgangsschaltung (128) mit dem Differenzverstärkerkern (122) und dem Differenzausgang (110) verbunden ist, wobei die Vorspannungsschaltung (124) mit dem Differenzverstärkerkern (122) und der Ausgangsschaltung (128) verbunden ist, wobei die Gleichtaktsteuerung (120) mit dem Differenzausgang (110) des Differenzverstärkers (102) verbunden ist;

wobei die Ausgangsgleichtaktsteuerung (120) konfiguriert ist, um eine Gleichtaktausgangsspannung des Differenzverstärkers (102) basierend auf der Gleichtaktreferenzspannung ($V_{CMREF}$) zu steuern oder zu regeln;

wobei die Ausgangsgleichtaktsteuerung (120) konfiguriert ist, um einen Biasstrom (126), der durch die Vorspannungsschaltung (124) für den Differenzverstärkerkern (122) bereitgestellt wird, basierend auf der Gleichtaktreferenzspannung ($V_{CMREF}$) zu steuern oder zu regeln;

wobei die Ausgangsgleichtaktsteuerung (120) konfiguriert ist, um einen Biasstrom (130), der durch die Vorspannungsschaltung (124) für die Ausgangsschaltung (128) basierend auf der Gleichtaktreferenzspannung ($V_{CMREF}$) bereitgestellt wird, zu steuern oder zu regeln;

wobei die Ausgangsgleichtaktsteuerung (120) konfiguriert ist, um den Biasstrom (126, 130), der durch die Vorspannungsschaltung (124) bereitgestellt wird, ferner basierend auf den Ausgangsspannungen ($V_{OUT1}$, $V_{OUT2}$), die an dem Differenzausgang (110) des Differenzverstärkers (102) bereitgestellt werden, zu steuern oder zu regeln;

wobei die Ausgangsgleichtaktsteuerung (120) konfiguriert ist, um die Ausgangsspannungen ($V_{OUT1}$, $V_{OUT2}$), die an dem Differenzausgang (110) des Differenzverstärkers (102) bereitgestellt werden, unter Verwendung eines Widerstandsnetzwerks zu mitteln, und um den Biasstrom (126, 130), der durch die Vorspannungsschaltung (124) bereitgestellt wird, unter Verwendung der gemittelten Spannungen zu steuern oder zu regeln;

wobei die Ausgangsschaltung (128) konfiguriert ist, um die Gegentaktausgangsspannung ($V_{out}$) basierend auf Biasströmen (130), die durch die Vorspannungsschaltung (124) bereitgestellt werden, und Strömen, die durch den Differenzverstärkerkern (122) bereitgestellt werden, bereitzustellen, und somit dem Differenzverstärker (122) einen hohen Differenzgewinnmodus und eine hochgenaue Ausgangsgleichtaktspannungsregelung bereitzustellen, was zu einer verbesserten Genauigkeit und Linearität der Sensoranordnung (100) führt.

3. Sensoranordnung (100) gemäß Anspruch 1, bei der Widerstandswerte der Rücckopplungswiderstände (Rfb1, Rfb2) zumindest um einen Faktor von zehn größer sind als Widerstandswerte der resistiven Sensorelemente (Rs1, Rs2), so dass die Ausgangsspannung ($V_{OUT2}$-$V_{OUT1}$), die an dem Differenzausgang (110) des Differenzverstärkers (102) bereitgestellt wird, unabhängig ist von dem Wert der Rücckopplungswiderstände (Rfb1, Rfb2), während die Gleichtaktreferenzspannung ($V_{CMREF}$) eine nutzerdefinierte Spannung ist.

4. Sensoranordnung (100) gemäß Anspruch 1, bei der Widerstandswerte der Rücckopplungswiderstände (Rfb1, Rfb2) um weniger als einen Faktor von zehn größer sind als Widerstandswerte der resistiven Sensorelemente (Rs1, Rs2), so dass die Ausgangsspannung ($V_{OUT2}$-$V_{OUT1}$), die an dem Differenzausgang (110) des Differenzverstärkers (102) bereitgestellt wird, von dem Wert der Rückkopplungswiderstände (Rfb1, Rfb2) abhängt, falls die Gleichtaktreferenzspannung ($V_{CMREF}$) eine nutzerdefinierte Spannung ist;

wobei ein Biaskompensationsteilsystem (140) konfiguriert ist, um die Gleichtaktreferenzspannung ($V_{CMREF}$) für den Differenzverstärker (102) unter Verwendung einer nutzerdefinierten Referenzspannung ($V_{REF}$) und eines Referenzwiderstandsnetzwerks (142) bereitzustellen, das einen Referenzrückkopplungswiderstand (Rfb3) und ein resistives Referenzsensorelement (Rs3) aufweist, wobei der Referenzrückkopplungswiderstand (Rfb3) einen Widerstandswert aufweist, der äquivalent ist zu den Widerstandswerten der Rückkopplungswiderstände (Rfb1, Rfb2), und wobei das resistive Referenzsensorelement (Rf3) einen Widerstandswert aufweist, der äquivalent ist zu dem Widerstandswert der resistiven Sensorelemente (Rs1, Rs2), womit die Eingabe (140) des Differenzverstärkers (102) mit der Gleichtaktreferenzspannung ($V_{CMREF}$) mit Selbstkompensationseigenschaften bereitgestellt wird, so dass die Ausgangsspannung ($V_{OUT2}$-$V_{OUT1}$), die an dem Differenzausgang (110) des Differenzverstärkers (102) bereitgestellt wird, von dem Wert der Widerstände (Rfb1, Rfb2) unabhängig ist.

5. Sensoranordnung (100) gemäß Anspruch 1, bei der der erste Rückkopplungswiderstand (Rfb1) der zwei Rückkopplungswiderstände (Rfb1, Rfb2) und das erste resistive Sensorelement (Rs1) der zwei resistiven Sensorelemente (Rs1, Rs2) in Reihe geschaltet sind zwischen den ersten Ausgangsanschluss (110_1) des Differenzausgangs (110) des Differenzverstärkers (102) und den Referenzanschluss (116);

wobei der zweite Rückkopplungswiderstand (Rfb2) der zwei Rückkopplungswiderstände (Rfb1, Rfb2) und das zweite resistive Sensorelement (Rs2) der zwei resistiven Sensorelemente (Rs1, Rs2) in Reihe geschaltet ist zwischen den zweiten Ausgangsanschluss (110_2) des Differenzausgangs (110) des Differenzverstärkers (102) und den Referenzanschluss (116); und

wobei die Ausgangsschaltung (128) des Differenzverstärkers (102) einen sechsten PMOS-Transistor (P6) und einen siebten PMOS-Transistor (P7) aufweist, wobei ein Kanal des sechsten PMOS-Transistors (P6) zwischen einen positiven Versorgungsknoten (162) des Differenzverstärkers (102) und den zweiten Ausgang (110_2) des Differenzverstärkers (102) geschaltet ist, und wobei ein Kanal des siebten PMOS-Transistors (P7) zwischen den positiven Versorgungsknoten (162) des Differenzverstärkers (102) und den ersten Ausgang (110_1) des Differenzverstärkers (102) geschaltet ist, wodurch die Transistoren (P7 und P6) des Verstärkers (102) und die beiden resistiven Sensorelemente (Rs1, Rs2) mit dem gleichen Strom vorgespannt werden, womit die Leistungsaufnahme der Sensoranordnung (100) reduziert wird.

6. Verfahren zum Betreiben der Sensoranordnung gemäß Anspruch 1, wobei das Verfahren folgenden Schritt aufweist:
Bereitstellen eines Bias für den Sensor basierend auf der Gleichtaktreferenzspannung ($V_{CMREF}$), die als eine Steuerrreferenz für den Ausgangsgleichtakt des Differenzverstärkers bereitgestellt wird.

## Revendications

1. Aménagement de capteur (100), comprenant:

un amplificateur différentiel (102) comprenant une entrée différentielle (108) présentant une première borne d'entrée (108_1) et une deuxième borne d'entrée (108_2), une sortie différentielle (110) présentant une première borne de sortie (110_1) et une deuxième borne de sortie (110_2) et une entrée de tension de référence en mode commun (114);
un capteur (104) connecté à l'entrée différentielle (108) de l'amplificateur différentiel (102), où le capteur (104) comprend deux éléments capteurs résistifs (Rs1, Rs2), où un premier élément capteur résistif (Rs1) des deux des éléments capteurs résistifs (Rs1, Rs2) est connecté à la première entrée (108_1) de l'amplificateur différentiel (102), où un deuxième élément capteur résistif (Rs2) des deux éléments capteurs résistifs (Rs1, Rs2) est connecté à la deuxième entrée (108_2) de l'amplificateur différentiel (102);
un trajet de rétroaction différentiel (112) comprenant un premier trajet de rétroaction (112_1) de la première borne de sortie (110_1) de la sortie différentielle (110) à la première borne d'entrée (108_1) de l'entrée différentielle (108) et un deuxième trajet de rétroaction (112_2) de la deuxième sortie (110_2) de la sortie différentielle (110) à la deuxième entrée (108_2) de l'entrée différentielle (108) de l'amplificateur différentiel (102), où le trajet de rétroaction différentiel (112) comprend deux résistances de rétroaction (Rfb1; Rfb2) de valeur égale, où le premier trajet de rétroaction (112_1) comprend la première résistance de rétroaction (Rfb1) et où le deuxième trajet de rétroaction (112_2) comprend la deuxième résistance de rétroaction (Rfb2);
dans lequel l'amplificateur différentiel (102) est configuré pour maintenir la moyenne des tensions entre, en premier lieu, la deuxième borne de sortie (110_2) de l'amplificateur différentiel (102) et la borne de référence (116) du capteur (104), et, en deuxième lieu, la première borne de sortie (110_1) de l'amplificateur différentiel (102) et la borne de référence (116) du capteur (104) égale à une tension de référence par une rétroaction en mode commun, fournissant ainsi aux résistances de capteur (Rs1, Rs2) un courant de polarisation à travers les première et deuxième bornes de sortie (110_1, 110_2) de l'amplificateur différentiel (102) et les première et deuxième résistances de rétroaction (Rfb1, Rfb2); et
dans lequel l'amplificateur différentiel (102) est configuré pour maintenir la différence de tension entre les première et deuxième bornes d'entrée (108_1, 108_2) de l'amplificateur différentiel (102) à zéro par une rétroaction en mode différentiel exécutée par les première et deuxième bornes de sortie (110_1, 110_2) de l'amplificateur différentiel (102) par l'intermédiaire des première et deuxième résistances de rétroaction (Rfb1, Rfb2), fournissant ainsi une amplification du signal de capteur et une conversion en une tension de sortie ($V_{OUT}$, $V_{OUT2}$-$V_{OUT1}$) présente entre les première et deuxième bornes de sortie (110_1, 110_2).

2. Aménagement de capteur (100) selon la revendication 1, dans lequel l'amplificateur différentiel (102) comprend une commande de mode commun de sortie (120), un noyau d'amplificateur différentiel (122), un circuit de sortie (128) et un circuit de polarisation (124);

dans lequel le noyau d'amplificateur différentiel (122) est connecté à l'entrée différentielle (108), dans lequel le circuit de sortie (128) est connecté au noyau d'amplificateur différentiel (122) et à la sortie différentielle (110), dans lequel le circuit de polarisation (124) est connecté au noyau d'amplificateur différentiel (122) et au circuit de sortie (128), dans lequel la commande de mode commun (120) est connectée à la sortie différentielle (110) de l'amplificateur différentiel (102);

dans lequel la commande de mode commun de sortie (120) est configurée pour commander ou réguler une tension de sortie de mode commun de l'amplificateur différentiel (102) sur base de la tension de référence de mode commun ($V_{CMREF}$);

dans lequel la commande de mode commun de sortie (120) est configurée pour commander ou réguler un courant de polarisation (126) fourni par le circuit de polarisation (124) pour le noyau d'amplificateur différentiel (122) sur base de la tension de référence de mode commun ($V_{CMREF}$);

dans lequel la commande de mode commun de sortie (120) est configurée pour commander ou réguler un courant de polarisation (130) fourni par le circuit de polarisation (124) pour le circuit de sortie (128) sur base de la tension de référence de mode commun ($V_{CMREF}$);

dans lequel la commande de mode commun de sortie (120) est configurée pour commander ou réguler le courant de polarisation (126, 130) fourni par le circuit de polarisation (124) par ailleurs sur base des tensions de sortie ($V_{OUT1}$, $V_{OUT2}$) fournies à la sortie différentielle (110) de l'amplificateur différentiel (102);

dans lequel la commande de mode commun de sortie (120) est configurée pour établir la moyenne des tensions de sortie ($V_{OUT1}$, $V_{OUT2}$) fournies à la sortie différentielle (110) de l'amplificateur différentiel (102) à l'aide d'un réseau de résistances, et pour commander ou réguler le courant de polarisation (126, 130) fourni par le circuit de polarisation (124) à l'aide des tensions moyennes;

dans lequel le circuit de sortie (128) est configuré pour fournir la tension de sortie en mode différentiel ($V_{OUT}$) sur base des courants de polarisation (130) fournis par le circuit de polarisation (124) et les courants fournis par le noyau d'amplificateur différentiel (122), pourvoyant ainsi l'amplificateur différentiel (112) en un mode de gain différentiel élevé et en une régulation de tension de mode commun de sortie de haute précision qui résultent en une précision et linéarité améliorées de l'aménagement de capteur (100).

3. Aménagement de capteur (100) selon la revendication 1, dans lequel les valeurs de résistance des résistances de rétroaction (Rfb1, Rfb2) sont supérieures d'au moins un facteur de dix aux valeurs de résistance des éléments capteurs résistifs (Rs1, Rs2) de sorte que la tension de sortie ($V_{OUT2}$, $V_{OUT1}$) fournie à la sortie différentielle (110) de l'amplificateur différentiel (102) soit indépendante de la valeur des résistances de rétroaction (Rfb1, Rfb2), tandis que la tension de référence en mode commun ($V_{CMREF}$) est une tension définie par l'utilisateur.

4. Aménagement de capteur (100) selon la revendication 1, dans lequel les valeurs de résistance des résistances de rétroaction (Rfb1, Rfb2) sont supérieures de moins d'un facteur de dix aux valeurs de résistance des éléments capteurs résistifs (Rs1, Rs2) de sorte que la tension de sortie ($V_{OUT2}$, $V_{OUT1}$) fournie à la sortie différentielle (110) de l'amplificateur différentiel (102) dépende de la valeur des résistances de rétroaction (Rfb1, Rfb2) au cas où la tension de référence en mode commun ($V_{CMREF}$) est une tension définie par l'utilisateur;

dans lequel un sous-système de compensation de polarisation (140) est configuré pour fournir la tension de référence en mode commun ($V_{CMREF}$) pour l'amplificateur différentiel (102) à l'aide d'une tension de référence définie par l'utilisateur ($V_{REF}$) et d'un réseau de résistances de référence (142) comprenant une résistance de rétroaction de référence (Rfb3) et un élément capteur résistif de référence (Rs3), où la résistance de rétroaction de référence (Rfb3) comprend une valeur de résistance qui est équivalente aux valeurs de résistance des résistances de rétroaction (Rfb1, Rfb2), et où l'élément capteur résistif de référence (Rs3) comprend une valeur de résistance qui est équivalente à la valeur de résistance des éléments capteurs résistifs (Rs1, Rs2), fournissant ainsi à l'entrée (114) de l'amplificateur différentiel (102) la tension de référence en mode commun ($V_{CMREF}$) présentant des propriétés d'auto-compensation de sorte que la tension de sortie ($V_{OUT2}$, $V_{OUT1}$) fournie à la sortie différentielle (110) de l'amplificateur différentiel (102) soit indépendante de la valeur des résistances (Rfb1, Rfb2).

**5.** Aménagement de capteur (100) selon la revendication 1, dans lequel la première résistance de rétroaction (Rfb1) des deux résistances de rétroaction (Rfb1, Rfb2) et le premier élément capteur résistif (Rs1) des deux éléments capteurs résistifs (Rs1, Rs2) sont connectés en série entre la première borne de sortie (110_1) de la sortie différentielle (110) de l'amplificateur différentiel (102) et la borne de référence (116);

dans lequel la deuxième résistance de rétroaction (Rfb2) des deux résistances de rétroaction (Rfb1; Rfb2) et le deuxième élément capteur résistif (Rs2) des deux éléments capteurs résistifs (Rs1, Rs2) sont connectés en série entre la deuxième borne de sortie (110_2) de la sortie différentielle (110) de l'amplificateur différentiel (102) et la borne de référence (116); et

dans lequel le circuit de sortie (128) de l'amplificateur différentiel (102) comprend un sixième transistor PMOS (P6) et un septième transistor PMOS (P7), dans lequel un canal du sixième transistor PMOS (P6) est connecté entre un noeud d'alimentation positif (162) de l'amplificateur différentiel (102) et la deuxième sortie (110_2) de l'amplificateur différentiel 102, et dans lequel un canal du septième transistor PMOS (P7) est connecté entre le noeud d'alimentation positif (162) de l'amplificateur différentiel (102) et la première sortie (110_1) de l'amplificateur différentiel (102), polarisant ainsi les transistors (P7) et (P6) de l'amplificateur (102) et des deux éléments capteurs résistifs (Rs1, Rs2) avec le même courant, réduisant ainsi la consommation d'énergie de l'aménagement de capteur (100).

**6.** Procédé pour faire fonctionner l'aménagement de capteur selon la revendication 1, dans lequel le procédé comprend le fait de fournir une polarisation pour le capteur sur base de la tension de référence en mode commun ($V_{CMREF}$) fournie comme référence de commande pour le mode commun de sortie de l'amplificateur différentiel.

FIG 1

$V_{OUT} = V_{OUT2} - V_{OUT1}$

$V_{OUT2}$

$V_{OUT1}$

Aout

16

18

$V_{CM2}$

Rs2

Rs1

sensor

14

Vdd

12

Vdd

10

Abias

$V_{CMREF2}$

<u>100</u>

104

102

sensor

$V_{OUT}$

106     108

110

# FIG 2

FIG 3

FIG 4

FIG 5A

FIG 5B

FIG 5C

FIG 6A

FIG 6B

FIG 7

FIG 8

FIG 9

FIG 10

EP 2 784 521 B1

FIG 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7646190 B
- US 3665756 A
- US 5686826 A
- US 4345477 A
- US 7451655 B
- US 6724202 B2

- US 20110248783 A1
- US 4786993 A
- US 7961418 B2
- US 4492122 A
- EP 1790988 A

**Non-patent literature cited in the description**

- **O. LEMAN ; E. M. BOUJAMAA ; W. RAHAJANDRAIBE ; E. KUSSENER ; S. MEILLERE ; H. BARTHELEMY ; G. JOURDAN ; P. REY.** An inertial smart-sensor based on silicon nanowires for wireless sportive activity monitoring. *10th IEEE Conference on Sensors (SENSORS'11),* 28 October 2011

- **MARK LEMKIN ; BERNHARD E. BOSER.** A Three-Axis Micromachined Accelerometer with a CMOS Position-Sense Interface and Digital Offset-Trim Electronics. *IEEE JOURNAL OF SOLID-STATE CIRCUITS,* April 1999, vol. 34 (4